# EUROPEAN PATENT APPLICATION

(11) **EP 2 400 829 A2**
(43) Date of publication of application: **28.12.2011**
(21) Application number: 11168945.1
(22) Date of filing: 07.06.2011
(51) Int. Cl.: H05K 9/00

(54) **High frequency device and a printed board holding structure.**

(30) Priority: 22.06.2010 JP 2010141223
(71) Applicant: Mitsumi Electric Co., Ltd., Tama-shi, Tokyo 206-8567 (JP)
(72) Inventor: Kasahara, Shinobu, TOKYO, 206-8567 (JP)
(74) Representative: Le Forestier, Eric

(57) **Abstract**

A high frequency device includes a metal case; a printed board configured to be inserted in the case; a projecting part configured to project to an inside of the case; a solder guiding hole formed at the projecting part, the solder guiding hole being configured to guide solder from an internal circumferential side to an external circumferential side of the case, the solder being configured to connect the case and the printed board to each other; a board concave part formed in a position of the printed board, the position corresponding to the projecting part; and a land surface formed on the printed board along an edge of the board concave part, wherein the printed board is provided so that a part of the solder guiding hole is positioned above the land surface when the printed board is inserted in the case.

## Description

### CROSS-REFERENCE TO RELATED APPLICATIONS

This patent application is based upon and claims the benefit of priority of Japanese Patent Application No. 2010-141223 filed on June 22, 2010, the entire contents of which are incorporated herein by reference.

### BACKGROUND OF THE INVENTION

### 1. Field of the Invention

The present invention generally relates to high frequency devices and printed board holding structures. More specifically, the present invention relates to a high frequency device and a printed board holding structure having a metal case, and a printed board configured to be inserted into the case.

### 2. Description of the Related Art

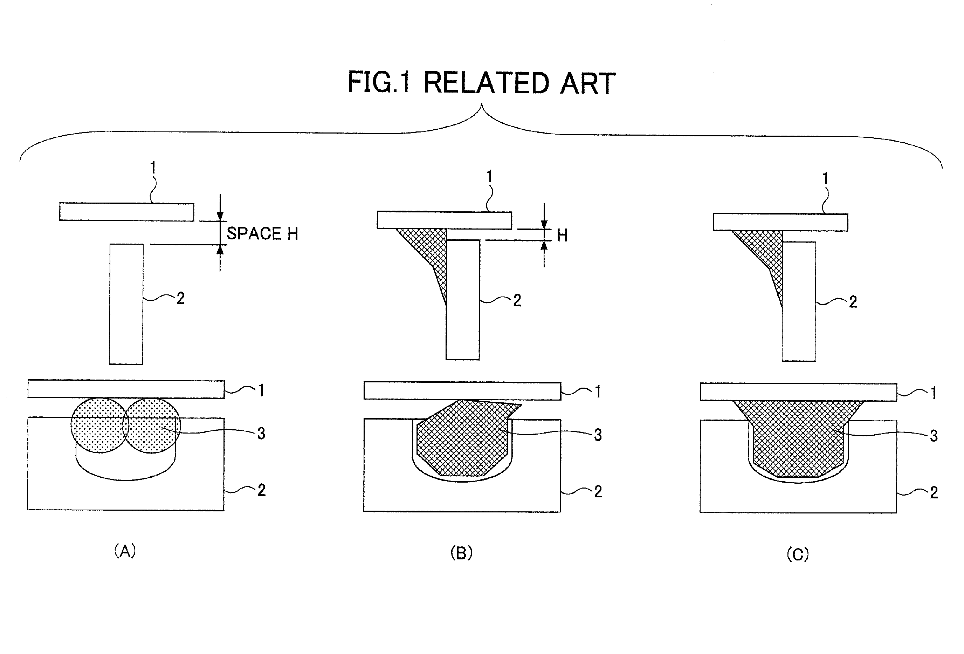

A structure, where a printed board having an electronic circuit mounted is inserted in and fixed to a metal case which also works as a shield plate, has been suggested as a high frequency device used for, for example, a television set. In such a high frequency device, the printed board and the case are soldered and fixed to each other by a reflow method using cream solder. With reference to FIG. 1, fixing of the printed board and the case in the related art high frequency device is discussed as follows. FIG. 1 is a view for explaining an example where a printed board and a case are fixed to each other.

It is normal practice, considering dimension error of each of the printed board and the case, to design so that a space of approximately 0.1 mm through approximately 0.2 mm between the printed board and the case is provided when the printed board is inserted in the case. When the printed board and the case are soldered, the space is filled with the solder so that the printed board and the case are fixed to each other.

FIG. 1(A) shows a state where cream solder 3 is applied between a case 1 and a printed board 2 in order to fill a space H between the case 1 and the printed board 2. FIG. 1(B) shows a state where the cream solder is melted by heating in the reflow process in the state shown in FIG. 1(A). FIG. 1(C) shows an ideal solder state when the case 1 and the printed board 2 are fixed to each other.

However, actually, in the state shown in FIG. 1(B) where the solder is melted by the reflow process, unevenness in the spreading of the solder (solder configuration) to contact the heated case 1 is generated due to the difference of heat capacity between the space H and the case 1 and the printed board 2. Therefore, the state shown in FIG. 1(C) may not be formed.

In the related art, means reducing such unevenness are considered. For example, a frame and a printed board having the following structure have been suggested in Japanese Laid-Open Patent Application Publication No. 8-56085. The frame includes a claw part and a projecting part. The claw part extends to an upper or lower part of an end part of a receiving part bent and projecting from a side plate. The projecting part projects to an inside. The printed board includes a through hole configured to receive the claw part and is received by the projecting part.

Japanese Laid-Open Patent Application Publication No. 11-121945 describes a structure having a frame having a side plate with end surfaces where at least an upper part is opened. The printed board is provided at an internal surface of the side plate situated inside the frame. Japanese Laid-Open Patent Application Publication No. 7-122874 describes a structure where a concave part is provided at a metal frame corresponding to both ends of a portion connected to a board.

However, in techniques discussed in, for example, Japanese Laid-Open Patent Application Publication No. 8-56085 and Japanese Laid-Open Patent Application Publication No. 11-121945, since the opening part is formed in the frame, an effect as a shield is degraded. Therefore, it is difficult to keep good electric properties, such as a GND property or a shield property. In addition, since the opening part is formed in the frame, it is difficult to keep the strength of the frame sufficient. Furthermore, in a technique discussed in Japanese Laid-Open Patent Application Publication No. 7-122874, the concave part is provided in the metal frame. Since an area of the concave part is large, spreading of the solder is not sufficient so that it may be difficult to make the part connected to the board have a stable solder configuration.

### SUMMARY OF THE INVENTION

Accordingly, embodiments of the present invention may provide a novel and useful high frequency device and a printed board holding structure solving one or more of the problems discussed above.

More specifically, the embodiments of the present invention may provide a high frequency device and a printed board holding structure where a printed board and a case can be stably soldered in a simple step in a reflow process and good electric capabilities can be obtained.

Another aspect of the embodiments of the present invention may be to provide a high frequency device, including a metal case; a printed board configured to be inserted in the case; a projecting part configured to project to an inside of the case; a solder guiding hole formed at the projecting part; a board concave part formed in a position of the printed board, the position corresponding to the projecting part; and a land surface formed on the printed board along an edge of the board concave part, wherein the printed board is provided so that a part of the solder guiding hole is positioned above the land surface when the printed board is inserted in the case.

Another aspect of the embodiments of the present invention may be to provide a printed board holding structure including a metal case and a printed board configured to be inserted in the case, the printed board holding structure being configured to hold the printed board, the printed board holding structure including a projecting part configured to project to an inside of the case; a solder guiding hole formed at the projecting part; a board concave part formed in a position of the printed board, the position corresponding to the projecting part; and a land surface formed on the printed board along an edge of the board concave part, wherein the printed board is provided so that a part of the solder guiding hole is positioned above the land surface when the printed board is inserted in the case.

Additional objects and advantages of the embodiments are set forth in part in the description which follows, and in part will become obvious from the description, or may be learned by practice of the invention. The object and advantages of the invention will be realized and attained by means of the elements and combinations particularly pointed out in the appended claims. It is to be understood that both the foregoing general description and the following detailed description are exemplary and explanatory and are not restrictive of the invention as claimed.

### BRIEF DESCRIPTION OF THE DRAWINGS

FIG. 1 is a view for explaining an example where a printed board and a case are fixed to each other;
FIG. 2 is a perspective view of a high frequency device of an embodiment of the present invention;
FIG. 3 is a side view of the high frequency device seen in an A direction in FIG. 2;
FIG. 4 is a cross-sectional view taken along a line B-B and a top view of the high frequency device of FIG. 2;
FIG. 5 is a view for explaining soldering of the case and the printed board of the embodiment of the present invention;
FIG. 6 is a view for explaining a state where the case and the printed board of the embodiment of the present invention are soldered;
FIG. 7 is a view for explaining application of cream solder;
FIG. 8 is a view showing a first modified example;
FIG. 9 is a view showing a second modified example; and
FIG. 10 is a view showing a third modified example.

### DETAILED DESCRIPTION OF THE PREFERED EMBODIMENTS

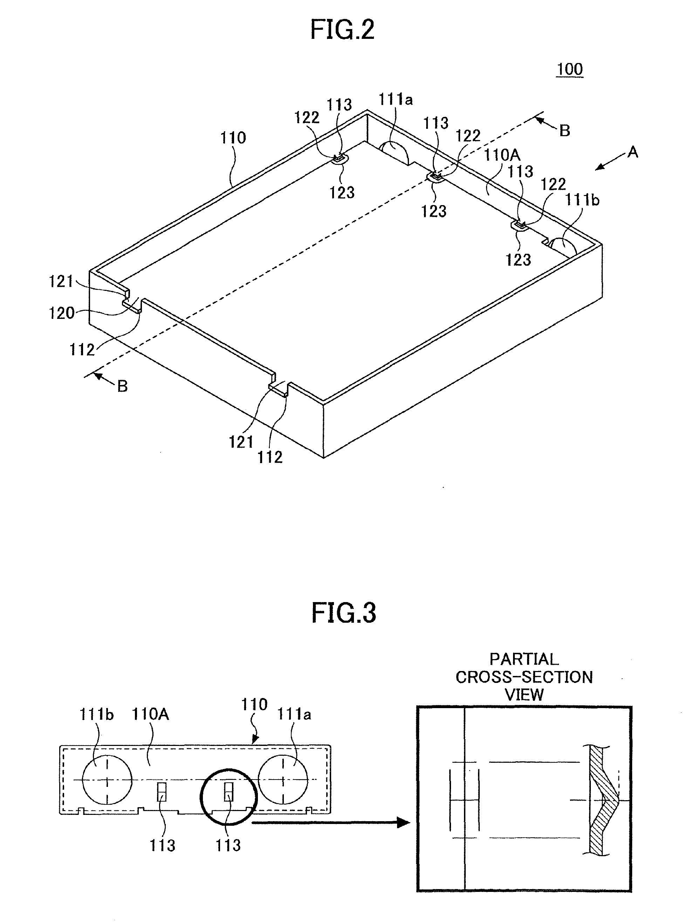

A description is given below, with reference to the FIG. 2 through FIG. 10 of embodiments of the present invention.

In the embodiments of the present invention, a projecting part is formed at a metal case. The projecting part is formed in a body with the case. The projecting part is configured to project to an inside of the case. A solder guiding hole is formed at a part of the projecting part. The solder is guided from the inside to the outside of the case by the solder guiding part. The projecting part is engaged with a concave part of the printed board and soldering is performed in a reflow process.

FIG. 2 is a perspective view of a high frequency device of an embodiment of the present invention. In a high frequency device 100 of the embodiment of the present invention, a printed board 120 is fitted into a metal case 110. Opening parts 111a and 111b and notch parts 112 are formed in the case 110. The opening parts 111a and 111b are configured to connect a connector. The connector is configured to input and output a video signal. The notch parts 112 are configured to determine a position where the printed board 120 is fitted in the case 110. Various kinds of electronic circuits for performing as the high frequency device 100 are mounted on the printed board 120 (not illustrated in FIG. 2). In addition, claw parts 121 are formed at the printed board 120. By engaging the claw parts 121 with the notch parts 112, a position for fixing the printed board 120 is determined. A bottom plate and a lid part are provided at the case 110 so as to cover the printed board 120.

Projecting parts 113 are formed at the case 110 of the embodiment of the present invention. The projecting parts 113 are configured to aid in soldering the printed board 120 and the case 110. At the case 110 of the embodiment of the present invention, two of the projecting parts 113 are provided between the opening part 111a and the opening part 111b. A single projecting part 113 is provided at each of two side plates perpendicular to a side plate 110A where the opening parts 111a and 111b are formed. Details of a structure of the projecting part 113 are discussed below.

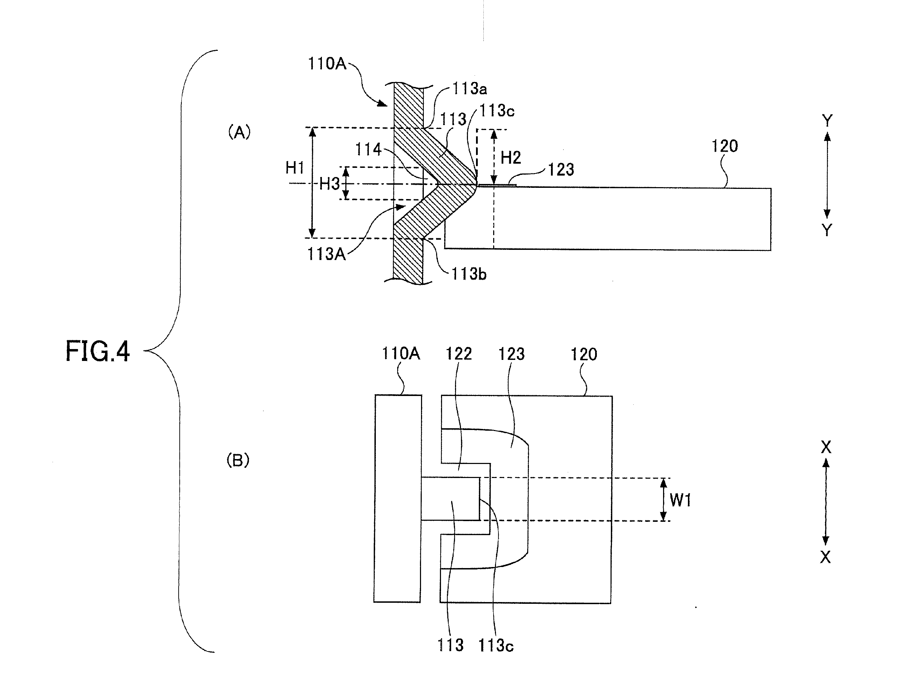

Concave parts 122 are formed at the printed board 120 of the embodiment of the present invention. The projecting parts 113 are engaged with the concave parts 122. The concave parts 122 are formed in positions where the projecting parts 113 are engaged when the printed board 120 is fixed to the case 110. A land part 123 is formed at the printed board 120 along a periphery of the concave part 122. The land part 123 may be formed so as to have, for example, a semicircular-shaped configuration or a configuration of half of an ellipse. The land part 123 may have a configuration where a head end of a semicircle is cut in a straight line manner (see FIG. 4(B)).

Details of the projecting part 113 of the embodiment of the present invention are further discussed. FIG. 3 is a side view of the high frequency device 100 seen in an A direction in FIG. 2. In this embodiment, the projecting part 113 may be formed by pressing the side plate 110A of the case 110 from an outside to an inside. The projecting part 113 has a bending configuration where the head projects inside to the side plate 110A.

FIG. 4(A) is a cross-sectional view taken along a line B-B of the high frequency device 100. FIG. 4(B) is a top view in a state where the projecting part 113 is engaged with the concave part 122.

As shown in FIG. 4(A), the projecting part 113 of the embodiment of the present invention has a bending configuration where a part of the side plate 110A is pressed to the inside of the case 110. In addition, in this embodiment, an upper end part 113a and a lower end part 113b of the projecting part 113 are not separated from the side plate 110A. The projecting part 113 is formed so as to be continuous with the side plate 110A in a Y-Y direction.

In this embodiment, by forming the projecting part 113 configured to project to the inside of the case 110, a solder guiding hole 114 is formed in a concave part 113A. The concave part 113A is formed at the external circumferential surface of the case 110. The solder guiding hole 114 is configured to guide the molten solder to the side of the case 110.

Assuming that a width of the projecting part 113 between the upper end part 113a and the lower end part 113b is defined as H1, the printed board 120 is provided so that the distance between the upper end part 113a and the land part 123 on the printed board 120 is H2. In this embodiment, the distance H2 is approximately 1/2 of the width H1. The printed board 120 is provided so that a head end part 113c of the projecting part 113 is positioned on the same plane surface as the land part 123.

It may not be necessary that the distance H2 is 1/2 of the width H1. In this embodiment, the printed board 120 may be provided so that the land part 123 may be positioned in an area of a width H3 of the solder guiding hole 114 in the Y-Y direction. By this arrangement, when the cream solder applied on the land part 123 becomes liquid, it is possible to guide the liquid solder to the solder guiding hole 114. Furthermore, a width W1 in the X-X direction of the projecting part 113 of this embodiment is approximately 1 mm. See FIG. 4(B).

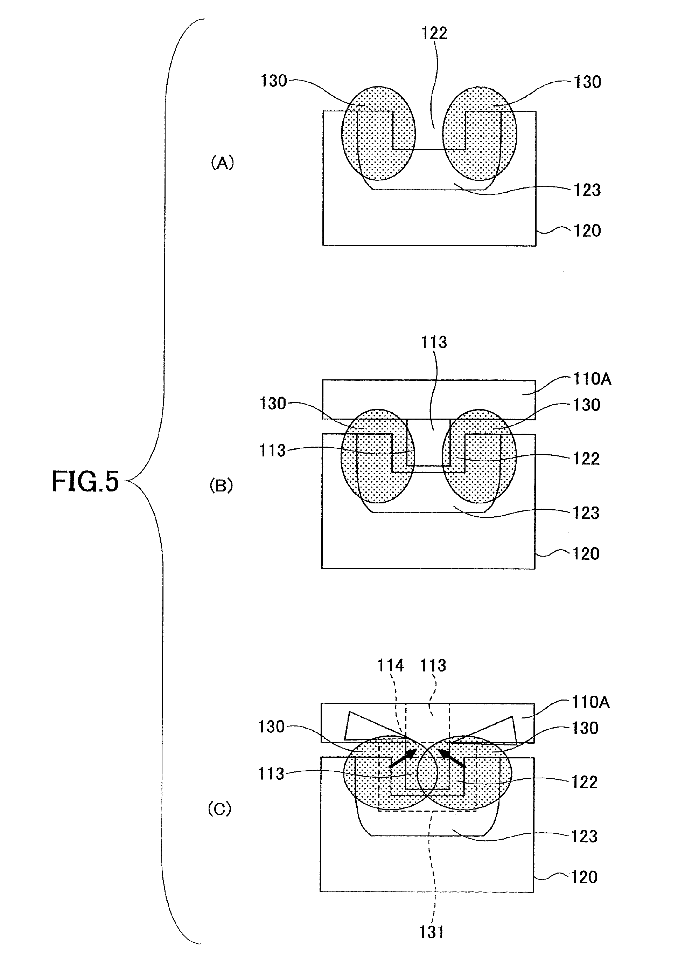

Next, soldering of the case 110 and the printed board 120 of the embodiment of the present invention is discussed with reference to FIGs. 5(A)-5(C). FIGs. 5(A)-5(C) are views for explaining soldering of the case 110 and the printed board 120 of the embodiment of the present invention.

In this embodiment, first, in a step shown in FIG. 5(A), cream solder 130 is applied on the land parts 123 of the printed board 120. After the cream solder 130 is applied on the land parts 123, the printed board 120 is inserted into the case 110 as shown in FIG. 5(B). At this time, the projecting parts 113 formed at the case 110 are engaged with the corresponding concave parts 122 of the printed wiring board 120.

In this state, when the printed board 120 is engaged with the case 110, heating is applied by a reflow process. By this heating, the cream solder 130 applied on the land part 123 is melted and becomes liquid so as to be spread into a solder configuration whereby the case 110 and the printed board 120 are fixed to each other.

Next, melting of the cream solder 130 of this embodiment is discussed with reference to FIG. 5(C).

By applying heat in the state shown in FIG. 5(B), the liquid solder flows in the space between the head end of the projecting part 113 and the concave part 122. As a result of this, the liquid solder goes to the external circumferential side of the case 110 due to capillarity generated by the solder guiding hole 114 formed at the projecting part 113, so as to flow into the concave part 113A formed at the external circumferential surface of the case 110. The capillarity is a phenomenon where liquid situated inside a narrow pipe may go up (against gravity) inside the pipe.

By this flow of the solder, the liquid solder comes together at a portion where the projecting part 113 and the land part 123 are connected to each other. At the same time, the flow of the liquid solder is spread to right and left uniformly at the internal circumferential surface of the side plate 110A of the case 110, so that a solder surface is formed.

As a result of this, in this embodiment, a large area between the projecting part 113 and the side plate 110A is covered with the solder. The solder guiding hole 114 is blocked with the guided solder.

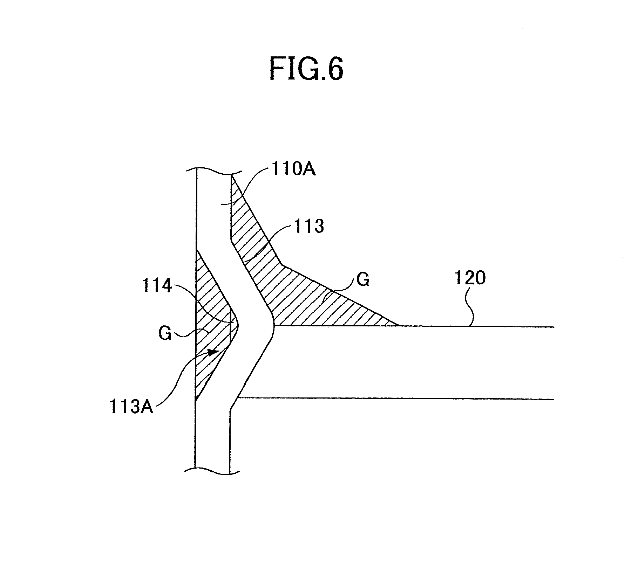

FIG. 6 is a view for explaining a state where the case 110 and the printed board 120 of the embodiment of the present invention are soldered. As shown in FIG. 6, in this embodiment, the concave part 113A of the projecting part 113 is filled with solder G so that the solder guiding hole 114 is blocked by the solder G. In addition, the printed board 120 and a part of the projecting part 113 situated above the surface of the printed board 120 where the land part 123 is formed, are connected to each other by the solder F having a large area.

In this embodiment, with this structure, the case 110 and the printed board 120 can be fixed to each other with a large area. In addition, the part where the case 110 and the printed board 120 are connected to each other can have a stable solder configuration. Furthermore, in this embodiment, since the solder guiding hole 114 is blocked in the soldering step, it is possible to improve the shield effect of the case 110 so that good electric properties can be kept. In addition, in this embodiment, since the projecting part 113 is provided in the vicinity of a connector configured to input and output video signals, it is possible to reduce noise or the like of the video signals. Furthermore, since no opening part is provided at the case 110 after the soldering is completed, it is possible to maintain the strength of the case 110.

In addition, in this embodiment, the liquid solder spontaneously spreads between the projecting part 113 and the land part 123 by the capillarity. Therefore, when the cream solder 130 is applied on the land 123, the cream solder may be applied in a position of the solder guiding hole 114. Because of this, in this embodiment, after the cream solder 130 is applied on the land part 123, the printed board 120 can be inserted in the case 110. Therefore, regardless of the configuration of the case 110, it is possible to apply the cream solder by a device having a simple structure.

In a case where the above-discussed structure is not provided or a case of the related art structure, the act of guiding the solder to the case 110 of this embodiment is not performed. In order to perform well the soldering of the case 110, it is necessary to apply the cream solder to both the printed board 120 and the case 110 after the printed board 120 is inserted into the case 110. In this case, in order to apply the cream solder to the printed board 120 having been installed in the case 110, a device having a structure corresponding to the configuration of the case 110 is required. Therefore, large-sized equipment is required and flexibility of the equipment is degraded.

On the other hand, in this embodiment, after the cream solder is applied to the printed board 120, the printed board 120 can be installed in the case 110. Therefore, it is possible to directly apply the cream solder to the printed board 120. Hence, the cream solder can be applied by simple equipment.

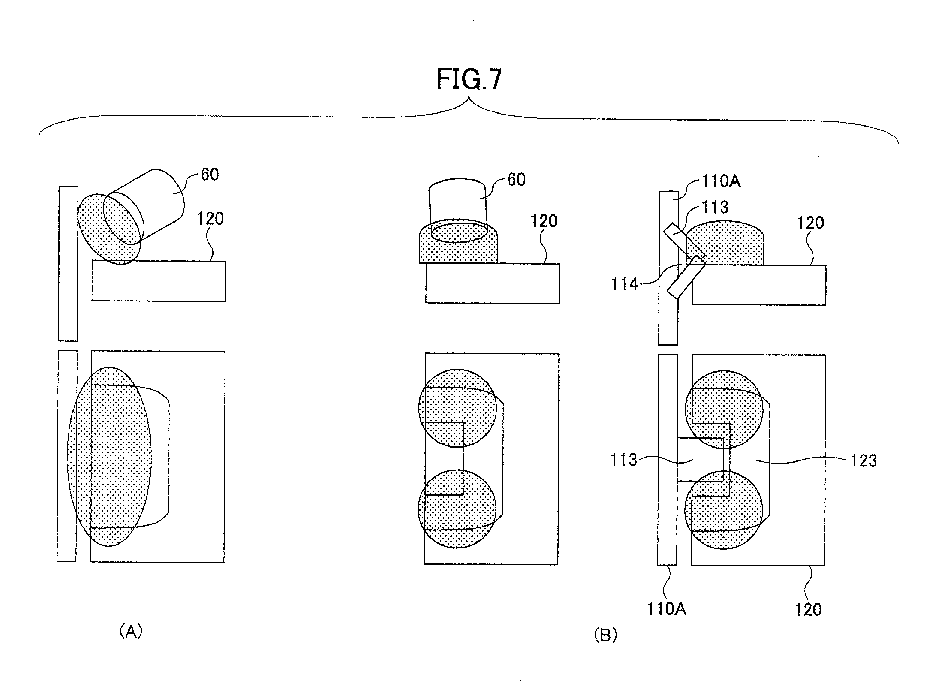

FIGs. 7(A) and 7(B) are views for explaining application of cream solder. FIG. 7(A) is a view for explaining a related art structure where the solder guiding hole 114 is not provided. FIG. 7(B) is a view for explaining a structure where the solder guiding hole 114 is provided.

As shown in FIG. 7(A), in a situation where the solder guiding hole 114 is not provided, the cream solder is applied to both the printed board 120 and the case in the state where the printed board 120 is inserted into the case. In this situation, a cream solder applying pipe 60 for applying the cream solder should have a configuration corresponding to the case.

On the other hand, as shown in FIG. 7(B), in the case of this embodiment where the solder guiding hole 114 is provided, after the cream solder is applied to the printed board 120, the printed board 120 is inserted into the case 110. Therefore, it is not necessary for the configuration of the cream solder applying pipe 60 to correspond to the configuration of the case 110. Hence, it is possible to apply the cream solder by using the cream solder applying pipe having high flexibility.

According to the embodiments of the present invention, the printed board 120 and the case 110 can be stably soldered in a simple step in a reflow process and good electric capabilities (properties) can be obtained.

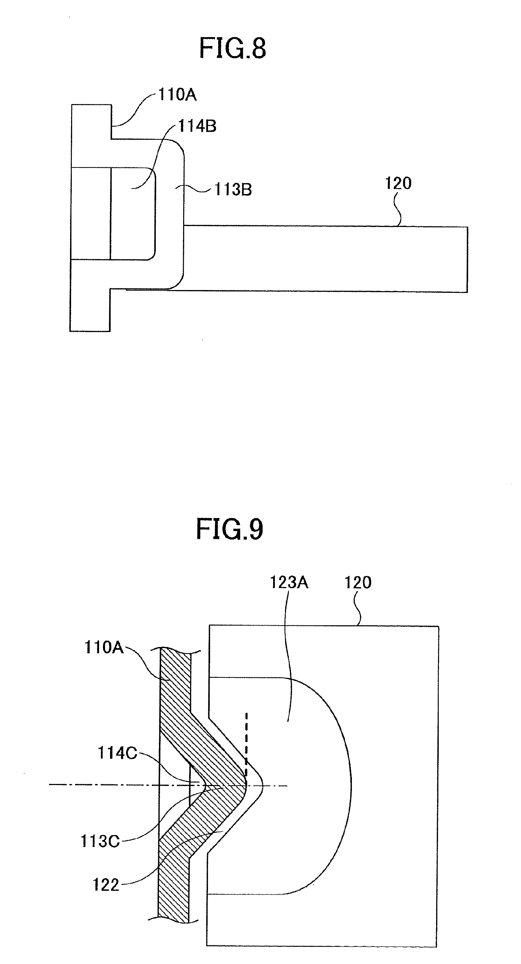

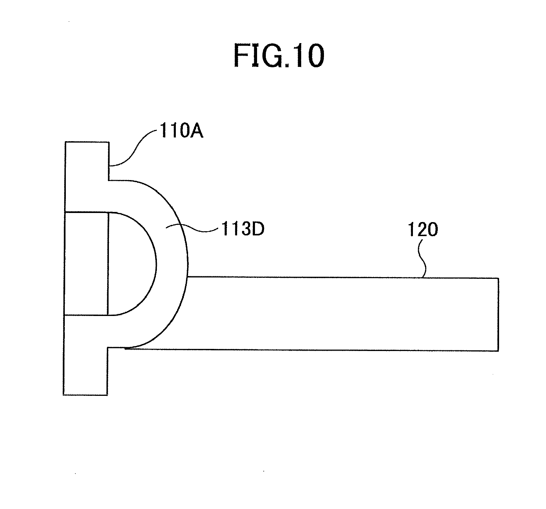

Modified examples of the embodiment of the present invention are discussed with reference to FIG. 8 through FIG. 10. FIG. 8 is a view showing a first modified example. FIG. 9 is a view showing a second modified example. FIG. 10 is a view showing a third modified example.

In the example shown in FIG. 8, a projecting part 113B does not have the bending configuration but a substantially square-shaped configuration. A solder guiding hole 114B is provided at the projecting part 113B shown in FIG. 8.

In the example shown in FIG. 9, a projecting part 113C is bent at approximately 90 degrees. A solder guiding hole 114C is provided at the projecting part 113C shown in FIG. 9.

In the example shown in FIG. 10, a projecting part 113D has a circular-shaped configuration. A solder guiding hole 114D is provided at a projecting part 113D shown in FIG. 10.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority or inferiority of the invention. Although the embodiments of the present invention have been described in detail, it should be understood that the various changes, substitutions, and alterations could be made hereto without departing from the spirit and scope of the invention.

Thus, according to the above-discussed embodiment of the present invention, the following high frequency device and printed board holding structure can be provided. In the following explanation, the numerical references are just for reference and therefore a scope of claims mentioned below is not limited by these numerical references.

One aspect of the embodiments of the present invention may be to provide a high frequency device (100), including a metal case (110); a printed board (120) configured to be inserted in the case (110); a projecting part (113) configured to project to an inside of the case (110); a solder guiding hole (114) formed at the projecting part (113); a board concave part (122) formed in a position of the printed board (120), the position corresponding to the projecting part (113); and a land surface (123) formed on the printed board (120) along an edge of the board concave part (122), wherein the printed board (120) is provided so that a part of the solder guiding hole (114) is positioned above the land surface (123) when the printed board (120) is inserted in the case (110).

The projecting part (113) may be formed so as to be continuous with a side plate in a long side direction or a short side direction of the side plate of the case (110) where the projecting part (113) is formed.

An upper end part and a lower end part of the projecting part may not be separated from the side plate and the projecting part may be formed so as to be continuous with the side plate.

The printed board (120) may be provided so that a head end (113c) of the projecting part (113) is positioned on a same plane surface as the land surface (123).

A case concave part (113A) may be formed at an external circumferential surface of the projecting part (113) along a configuration of the projecting part (113).

The projecting part (113) may have a bending configuration where a part of the side plate (110A) is pressed to the inside of the case (110).

The solder guiding hole (114) may be configured to guide solder from an internal circumferential side to an external circumferential side of the case (110), the solder being configured to connect the case (110) and the printed board (120) to each other.

Another aspect of the embodiments of the present invention may be to provide a printed board holding structure including a metal case (110) and a printed board (120) configured to be inserted in the case (110), the printed board holding structure being configured to hold the printed board (120), the printed board holding structure including: a projecting part (113) configured to project to an inside of the case (110); a solder guiding hole (114) formed at the projecting part (113); a board concave part (122) formed in a position of the printed board (120), the position corresponding to the projecting part (113); and a land surface (123) formed on the printed board (120) along an edge of the board concave part (122), wherein the printed board (120) is provided so that a part of the solder guiding hole (114) is positioned above the land surface (123) when the printed board (120) is inserted in the case (110).

According to the embodiments of the present invention, it is possible to provide a high frequency device and a printed board holding structure where a printed board and a case can be stably soldered in a simple step in a reflow process and good electric capabilities can be obtained.

## Claims

1. A high frequency device, comprising:
a metal case;
a printed board configured to be inserted in the case;
a projecting part configured to project to an inside of the case;
a solder guiding hole formed at the projecting part;
a board concave part formed in a position of the printed board, the position corresponding to the projecting part; and
a land surface formed on the printed board along an edge of the board concave part,
wherein the printed board is provided so that a part of the solder guiding hole is positioned above the land surface when the printed board is inserted in the case.

2. The high frequency device as claimed in claim 1,
wherein the projecting part is formed so as to be continuous with a side plate in a long side direction or a short side direction of the side plate of the case where the projecting part is formed.

3. The high frequency device as claimed in claim 1,
wherein an upper end part and a lower end part of the projecting part are not separated from the side plate and the projecting part is formed so as to be continuous with the side plate.

4. The high frequency device as claimed in claim 1,
wherein the printed board is provided so that a head end of the projecting part is positioned on a same plane surface as the land surface.

5. The high frequency device as claimed in claim 1,
wherein a case concave part is formed at an external circumferential surface of the projecting part along a configuration of the projecting part.

6. The high frequency device as claimed in claim 1,
wherein the projecting part has a bending configuration where a part of the side plate is pressed to the inside of the case.

7. The high frequency device as claimed in claim 1,
wherein the solder guiding hole is configured to guide solder from an internal circumferential side to an external circumferential side of the case, the solder being configured to connect the case and the printed board to each other.

8. A printed board holding structure including a metal case and a printed board configured to be inserted in the case, the printed board holding structure being configured to hold the printed board, the printed board holding structure comprising:
a projecting part configured to project to an inside of the case;
a solder guiding hole formed at the projecting part;
a board concave part formed in a position of the printed board, the position corresponding to the projecting part; and
a land surface formed on the printed board along an edge of the board concave part,
wherein the printed board is provided so that a part of the solder guiding hole is positioned above the land surface when the printed board is inserted in the case.
